# EUROPÄISCHE PATENTSCHRIFT

(11) **EP 1 173 882 B1**
(45) Veröffentlichungstag und Bekanntmachung des Hinweises auf die Patenterteilung: **31.05.2006**
(21) Anmeldenummer: 00929255.8
(22) Anmeldetag: 24.03.2000
(51) Int. Cl.: H01L 21/00

(54) **ANLAGE ZUR BEARBEITUNG VON WAFERN**
DEVICE FOR TREATING WAFERS
INSTALLATION POUR TRAITER DES PLAQUETTES DE SILICIUM

(30) Priorität: 26.03.1999 DE 19913918
(43) Veröffentlichungstag der Anmeldung: 23.01.2002
(73) Patentinhaber: Infineon Technologies AG, 81669 München (DE)
(72) Erfinder: HEINEMANN, Bernhard, D-86926 Greifenberg (DE)
(74) Vertreter: Epping - Hermann - Fischer
(86) Internationale Anmeldenummer: PCT/DE2000/000940
(87) Internationale Veröffentlichungsnummer: WO 2000/059001

(56) Entgegenhaltungen:
- PATENT ABSTRACTS OF JAPAN vol. 018, no. 449 (M-1660), 22. August 1994 (1994-08-22) -& JP 06 143067 A (SANDO YAKUHIN KK), 24. Mai 1994 (1994-05-24)
- PATENT ABSTRACTS OF JAPAN vol. 2000, no. 01, 31. Januar 2000 (2000-01-31) -& JP 11 283918 A (TOKYO ELECTRON LTD), 15. Oktober 1999 (1999-10-15)
- PATENT ABSTRACTS OF JAPAN vol. 1995, no. 06, 31. Juli 1995 (1995-07-31) -& JP 07 058073 A (SHARP CORP), 3. März 1995 (1995-03-03)

## Beschreibung

Die Erfindung betrifft eine Anlage zur Fertigung von Halbleiterprodukten gemäß dem Oberbegriff des Anspruchs 1.

Derartige Anlagen können insbesondere als Anlagen zur Bearbeitung von Wafern ausgebildet sein.

Diese Anlagen umfassen eine Vielzahl von Fertigungseinheiten, mit welchen unterschiedliche Fertigungsprozesse zur Bearbeitung der Wafer durchgeführt werden. Bei diesen Fertigungsprozessen handelt es sich insbesondere um Ätzprozesse, Naßchemieverfahren, Diffusionsprozesse sowie diverse Reinigungsverfahren wie zum Beispiel CMP-Verfahren (Chemical Mechanical Polishing). Für jeden dieser Fertigungsprozesse sind eine oder mehrere Fertigungseinheiten vorgesehen.

Der gesamte Bearbeitungsprozeß der Wafer unterliegt strengen Reinheitsanforderungen, so daß die Fertigungseinheiten in einem Reinraum oder in einem System von Reinräumen angeordnet sind.

Der Reinraum oder das System von Reinräumen ist üblicherweise auf einer Etage eines Gebäudes angeordnet.

Zur Ver- und Entsorgung von Betriebsstoffen für die einzelnen Fertigungseinheiten ist ein Versorgungssystem vorgesehen.

Zu derartigen Betriebsstoffen gehören insbesondere flüssige und gasförmige Betriebsstoffe. Als flüssige Betriebsstoffe werden insbesondere Reinwasser und Reinstwasser für eine Vielzahl von Fertigungsprozessen wie zum Beispiel Reinigungsverfahren, Ätz- und Diffusionsprozesse benötigt. Desweiteren wird als flüssiger Betriebsstoff Kühlwasser zur Kühlung von Maschinen und Anlagen in den einzelnen Fertigungseinheiten benötigt. Schließlich werden auch verschiedene Chemikalien in flüssiger Form oder im Gaszustand zur Durchführung unterschiedlicher Fertigungsprozesse benötigt.

Das Versorgungssystem weist mehrere Vorratsbehälter auf, in welchen die den Fertigungseinheiten zuzuführenden Betriebsstoffe gelagert sind. Zudem sind mehrere Vorratsbehälter vorgesehen, welchen Betriebsstoffe, die aus den Fertigungseinheiten abgeleitet werden, zugeführt werden. Es wird verwiesen auf den Stand der Technik im Dokument JP-A-6143067.

Die Vorratsbehälter des Versorgungssystems sind auf einer Etage oder mehreren Etagen des Gebäudes verteilt, welche unterhalb der Etage des Reinraums liegen.

Zur Versorgung der Fertigungseinheiten mit flüssigen Betriebsstoffen führen von den entsprechenden Vorratsbehältern Versorgungsleitungen zu den jeweiligen Fertigungseinheiten. Diese Versorgungsleitungen sind von den Vorratsbehältern nach oben zum Boden der Etage des Reinraums geführt und münden schließlich aus dem Boden aus um über Anschlüsse den Fertigungseinheiten zugeführt zu werden.

Nachteilig hierbei ist, daß die flüssigen Betriebsmittel mittels Pumpen in den Versorgungsleitungen nach oben gepumpt werden müssen, um sie den Fertigungseinheiten zuzuführen. Dies erfordert zum einen einen beträchtlichen Installationsaufwand. Zum anderen ist damit ein großer Energieverbrauch verbunden.

Typischerweise müssen die Flüssigkeiten in den Versorgungsleitungen Höhendifferenzen von 2 Metern bis zu 10 Metern überwinden. Zum Hochpumpen der Flüssigkeiten muß dabei der hydrostatische Druck in den Versorgungsleitungen überwunden werden. Zudem führen auch Reibungsverluste an den Innenrändern der Versorgungsleitungen beim Durchströmen der Flüssigkeiten zu einem beträchtlichen Energieaufwand.

In einigen Fertigungseinheiten entsteht während der Bearbeitung der Wafer Abluft, die einerseits kontaminiert ist und andererseits mehr oder minder stark erwärmt ist. Diese Abluft wird mit Gebläsen oder dergleichen aus der Fertigungseinheit abgesaugt und über Entsorgungsleitungen in einen Vorratsbehälter geführt, der sich in einer der unterhalb des Reinraums liegenden Etagen befindet.

Da die erwärmte Abluft innerhalb der Fertigungseinheit infolge von Konvektion nach oben steigt, ist ein großer Energieaufwand erforderlich, um die Abluft über die Entsorgungsleitungen in den unterhalb der Fertigungseinheit liegenden Vorratsbehälter abzusaugen.

Der Erfindung liegt die Aufgabe zugrunde ein Versorgungssystem für eine Anlage der eingangs genannten Art zu schaffen, mit welchem eine möglichst energiesparende und kostengünstige Versorgung und Entsorgung von Betriebsstoffen für die Fertigungseinheiten der Anlage ermöglicht wird.

Zur Lösung dieser Aufgabe sind die Merkmale des Anspruchs 1 vorgesehen. Vorteilhafte Ausführungsformen und zweckmäßige Weiterbildungen der Erfindung sind in den Unteransprüchen beschrieben.

Die erfindungsgemäße Anlage weist ein Versorgungssystem auf, welches erste Versorgungs- und Entsorgungsleitungen aufweist, in welchen Betriebsstoffe, welche schwerer als die umgebende Atmosphäre sind, von oben nach unten geführt sind und zweite Versorgungs- und Entsorgungsleitungen aufweist, in welchen die leichteren Betriebsstoffe von unten nach oben geführt sind.

Bei diesem Versorgungssystem erfolgt somit die Versorgung und Entsorgung von Betriebsstoffen nach dem Schwerkraftprinzip. Betriebsstoffe, welche schwerer als die umgebende Atmosphäre sind, werden in den ersten Versorgungsleitungen von oben nach unten geführt. Dabei werden insbesondere flüssige Betriebsstoffe, wie zum Beispiel Reinwasser, Reinstwasser oder Kühlwasser den Fertigungseinheiten von Vorratsbehältern aus zugeführt, welche oberhalb der jeweiligen Fertigungseinheiten angeordnet sind. Zweckmäßigerweise sind diese Vorratsbehälter in über dem Reinraum liegenden Etagen des Gebäudes, in welchem sich die Anlage befindet, angeordnet. Entsprechend führen die ersten Entsorgungsleitungen zu Vorratsbehältern in Etagen unterhalb des Reinraums. In diese Vorratsbehälter werden die Flüssigkeiten aus den Fertigungseinheiten abgelassen.

Diese Art der Zuführung und Entsorgung erfolgt mit einem minimalen Energieaufwand. Da die Flüssigkeiten schwerer als die umgebende Atmosphäre sind, wird durch das Eigengewicht die von oben nach unten gerichtete Fließbewegung der Flüssigkeiten in den ersten Versorgungs- und Entsorgungsleitungen unterstützt, so daß keine oder nur wenige Pumpensysteme vorgesehen werden müssen, um die Zuführung der Flüssigkeiten zu bewerkstelligen.

Entsprechend werden die Betriebsstoffe, die leichter als die umgebende Atmosphäre sind, in den zweiten Versorgungs- und Entsorgungsleitungen von unten nach oben geführt.

Beispielsweise wird erwärmte und kontaminierte Abluft über zweite Entsorgungsleitungen nach oben aus der Fertigungseinheit abgeführt. Zweckmäßigerweise wird diese Abluft in Vorratsbehältern aufgefangen, welche sich in oberhalb des Reinraums liegenden Etagen befinden.

Da die erwärmte und kontaminierte Abluft durch Konvektion in Richtung der Decke der Fertigungseinheit strömt, kann von dort die Abluft ohne großen Energie- und Materialaufwand von der Fertigungseinheit in die Entsorgungsleitungen abgesaugt werden.

Die Erfindung wird im nachstehenden anhand der Zeichnungen erläutert. Es zeigen:
- Figur 1:: Schematische Darstellung einer Anlage zur Bearbeitung von Wafern mit mehreren Fertigungseinheiten in einem Reinraum.
- Figur 2:: Querschnitt durch ein Gebäude mit einem auf einer Etage angeordneten Reinraum gemäß Figur 1 sowie einem über weitere Etagen verteilten Versorgungssystem.

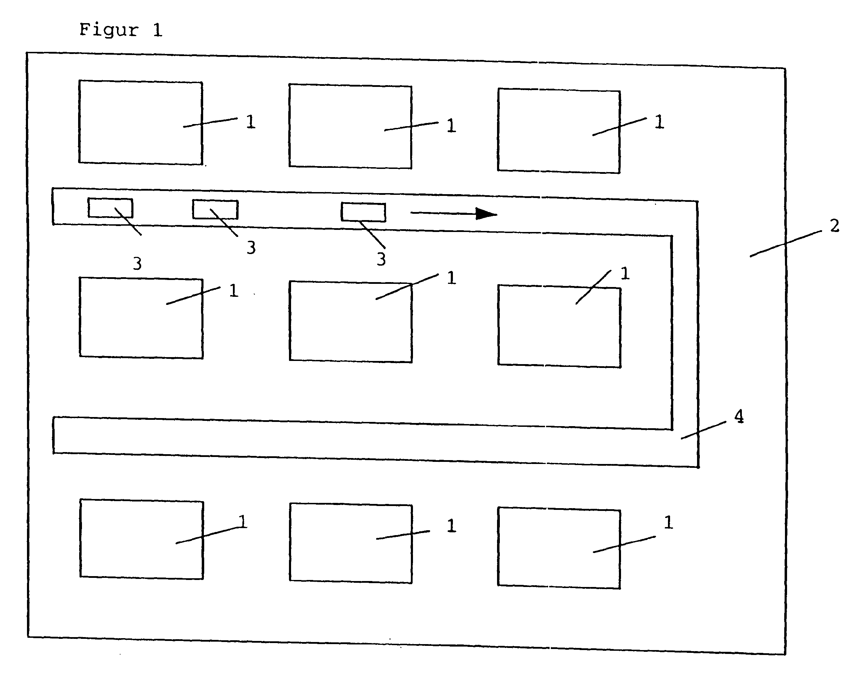

In Figur 1 ist eine Anordnung von Fertigungseinheiten 1 einer Anlage zur Bearbeitung von Wafern dargestellt. Die Fertigungseinheiten 1 sind in einem Reinraum 2 angeordnet und dienen zur Durchführung der bei der Bearbeitung der Wafer anfallenden Fertigungsprozesse. Diese Fertigungsprozesse umfassen insbesondere Ätzprozesse, Naßchemieverfahren, Diffusionsprozesse sowie Reinigungsverfahren. Für sämtliche Fertigungsprozesse sind eine oder mehrere Fertigungseinheiten 1 vorgesehen.

Die Fertigungseinheiten 1 sind über ein Transportsystem verbunden, wobei den Fertigungseinheiten 1 über das Transportsystem mit Wafern befüllte Kassetten 3 zugeführt werden. Das Transportsystem weist ein Fördersystem 4 wie zum Beispiel Rollenförderer oder Stetigföderer auf, auf welchen die Kassetten 3 transportiert werden. Zudem kann das Transportsystem eine vorgegebene Anzahl von nicht dargestellten Speichern zur Zwischenlagerung der Wafer aufweisen.

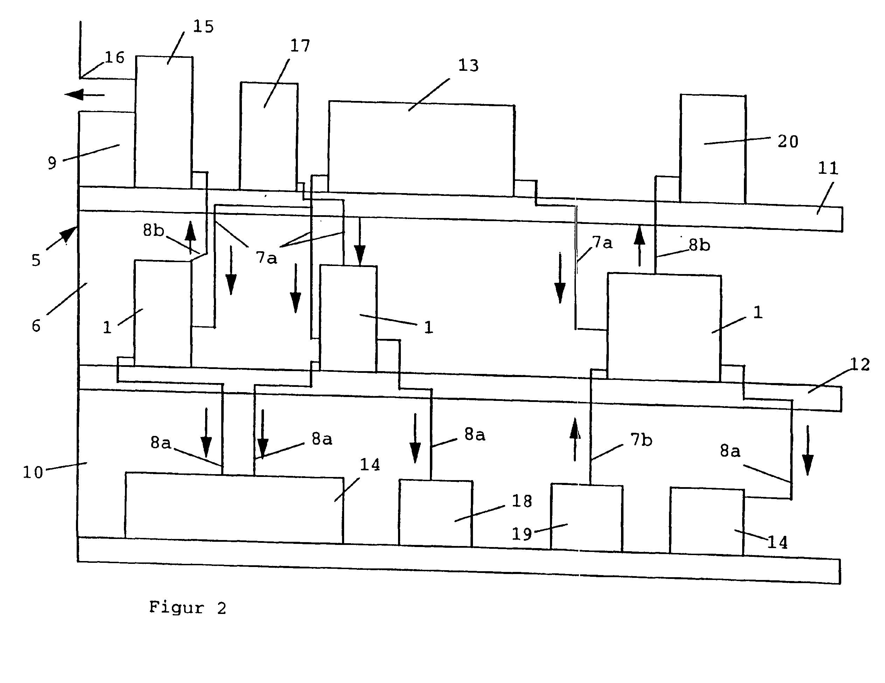

Wie aus Figur 2 ersichtlich ist, befindet sich die Fertigungseinheit 1 in einem Gebäude 5, wobei sich der Reinraum 2 mit den Fertigungseinheiten 1 auf einer Etage 6 des Gebäudes 5 befindet.

Die Anlage weist zudem ein Versorgungssystem zur Versorgung und Entsorgung von Betriebsstoffen auf, welche für die in den Fertigungseinheiten 1 durchgeführten Fertigungsprozesse benötigt werden.

Das Versorgungssystem weist mehrere Vorratsbehälter auf, in welchen entweder Betriebsstoffe gelagert sind, welche den Fertigungseinheiten 1 über Versorgungsleitungen 7a, 7b zugeführt werden. Zudem sind Vorratsbehälter vorgesehen, welchen Betriebsstoffe aus den Fertigungseinheiten 1 über Entsorgungsleitungen 8a, 8b zugeführt sind. Diese Vorratsbehälter sind im vorliegenden Ausführungsbeispiel in zwei verschiedenen Etagen 9, 10 des Gebäudes 5 angeordnet. Dabei befindet sich eine Etage 9 oberhalb der Etage 6 mit dem Reinraum 2, während die andere Etage 10 unterhalb der Etage 6 mit dem Reinraum 2 angeordnet ist.

Erfindungsgemäß sind die einzelnen Vorratsbehälter in den beiden Etagen 9, 10 so angeordnet, daß Betriebsstoffe, die schwerer als die umgebende Atmosphäre sind, den Fertigungseinheiten 1 über die ersten Versorgungsleitungen 7a zugeführt werden, welche von der über den Reinraum 2 liegenden Etage 9 durch die Decke 11 des Reinraums 2 zu den jeweiligen Fertigungseinheiten 1 geführt sind. Entsprechend werden die Betriebsstoffe, die schwerer als die umgebende Atmosphäre sind, über erste Entsorgungsleitungen 8a von den Fertigungseinheiten 1 nach unten abgeführt. Dabei verlaufen die Entsorgungsleitungen 8a durch den Boden 12 des Reinraums 2 und sind zu Vorratsbehältern in der Etage 10 unterhalb des Reinraums 2 geführt. Die umgebende Atmosphäre ist üblicherweise von Luft bei Raumtemperaturverhältnissen und bei Normaldruckverhältnissen gebildet.

Dagegen sind die Betriebsstoffe, die leichter als die umgebende Atmosphäre sind, über zweite Versorgungsleitungen 7b von Vorratsbehältern, welche in der Etage 10 unterhalb des Reinraums 2 angeordnet sind, zu den Fertigungseinheiten 1 geführt. Dabei verlaufen die zweiten Versorgungsleitungen 7b abschnittsweise im Boden 12 des Reinraums 2 und führen dann die Betriebsstoffe von unten nach oben verlaufend den Fertigungseinheiten 1 zu. Entsprechend werden Betriebsstoffe, die leichter als die umgebende Atmosphäre sind, über zweite Entsorgungsleitungen 8b von den Fertigungseinheiten 1 zu Vorratsbehältern geführt, welche in der Etage 9 oberhalb des Reinraums 2 angeordnet sind. Die abschnittsweise nach oben verlaufenden Entsorgungsleitungen 8b durchsetzen dabei die Decke 11 des Reinraums 2.

Bei den Betriebsstoffen, die schwerer als die umgebende Atmosphäre sind, handelt es sich insbesondere um Flüssigkeiten. Zudem können diese Betriebsstoffe auch von Gasen mit entsprechender Dichte und Temperatur gebildet sein.

Betriebsstoffe, die leichter als die umgebende Atmosphäre sind, sind vorwiegend von Gasen gebildet.

Als flüssige Betriebsstoffe werden typischerweise Reinwasser, Reinstwasser und Kühlwasser verwendet. Reinstwasser und Reinwasser wird für eine Vielzahl von Fertigungsprozessen benötigt, wie zum Beispiel Reinigungsprozessen und Diffusionsprozessen. Das Kühlwasser wird zur Kühlung von Maschinen und Anlagen in den einzelnen Fertigungseinheiten 1 benötigt. Zudem werden für unterschiedliche Fertigungsprozesse verschiedene Flüssig-Chemikalien eingesetzt. Bei diesen Flüssig-Chemikalien handelt es sich beispielsweise um Ätzlösungen zur Durchführung von Ätzprozessen, wie beispielsweise KOH und NaOH oder um alkalische oder saure Lösungen zur Reinigung der Wafer.

Beispiele für gasförmige Betriebsstoffe sind Ätzgase zur Durchführung von Ätzprozessen. Die Ätzgase können typischerweise von Halogenverbindungen gebildet sein. Desweiteren wird Sauerstoff zur Reinigung und heißer Stickstoff zur nachfolgenden Trocknung von Wafern eingesetzt.

Im allgemeinen umfassen Anlagen zur Bearbeitung von Wafern eine Vielzahl von Fertigungseinheiten 1 sowie eine Vielzahl von Vorratsbehältern für die Zufuhr von Betriebsstoffen zu den Fertigungseinheiten 1 sowie für aus den Fertigungseinheiten 1 abgeführte Betriebsstoffe.

In Figur 2 ist ein kleiner Ausschnitt einer derartigen Anlage zur Bearbeitung von Wafern dargestellt.

Bei dem in Figur 2 schematisch dargestellten Ausschnitt eines Gebäudes 5 sind in der mittleren Etage 6 im Reinraum 2 drei Fertigungseinheiten 1 dargestellt.

Auf der darüberliegenden Etage 9 ist ein als Wasserreservoir 13 ausgebildeter Vorratsbehälter vorgesehen, in welchem Reinstwasser gelagert ist. Im Bereich des Bodens des Wasserreservoirs 13 münden erste Versorgungsleitungen 7a aus, welche die drei Fertigungseinheiten 1 mit Reinstwasser versorgen.

Die Versorgungsleitungen 7a verlaufen zunächst in horizontaler Richtung in der Decke 11 des Reinraums 2 und münden dann senkrecht nach unten verlaufend zu den Fertigungseinheiten 1 aus. Die Versorgungsleitungen 7a münden über nicht dargestellte Anschlüsse in die Fertigungseinheiten 1 ein. Dabei ist die Einbauhöhe für die einzelnen Anschlüsse an den Fertigungseinheiten 1 so gewählt, daß das Reinstwasser in der jeweiligen Fertigungseinheit 1 in der benötigten Höhe über dem Boden 12 des Reinraums 2 zur Verfügung steht. Da die Versorgungsleitungen 7a das Reinstwasser nur in horizontaler Richtung oder senkrecht nach unten führen, wird für die Zufuhr des Reinstwassers zu den Fertigungseinheiten 1 keine oder nur eine sehr geringe Pumpleistung benötigt.

Im allgemeinen wird das Reinstwasser durch die Fertigungsprozesse in den Fertigungseinheiten 1 verschmutzt, so daß es nach einer vorgegebenen Zeit aus den Fertigungseinheiten 1 als Abwasser entfernt werden muß. Im vorliegenden Ausführungsbeispiel wird das Abwasser über erste Entsorgungsleitungen 8a aus den Fertigungseinheiten 1 in zwei als Auffangbehälter 14 ausgebildete Vorratsbehälter geleitet. Diese Auffangbehälter 14 sind in der Etage 10 unterhalb des Reinraums 2 angeordnet. Die Entsorgungsleitungen 8a münden an nicht dargestellten Anschlüssen an den Fertigungseinheiten 1 aus, verlaufen abschnittsweise in dem Boden 12 des Reinraums 2 in horizontaler Richtung und münden senkrecht nach unten verlaufend in Richtung der Auffangbehälter 14 aus dem Boden 12 des Reinraums 2 aus. Schließlich sind die Entsorgungsleitungen 8a über nicht dargestellte Anschlüsse in die Auffangbehälter 14 geführt. Das verschmutzte Abwasser in den Auffangbehältern 14 kann einer nicht dargestellten Recycling-Anlage zugeführt werden, in welcher aus dem Abwasser wieder Reinstwasser gewonnen wird. Auch in diesem Fall wird das Abwasser, welches schwerer als die umgebende Atmosphäre ist, über Entsorgungsleitungen 8a von oben nach unten geführt, so daß auch zur Entsorgung des Abwassers in die Auffangbehälter 14 keine oder nur eine geringe Pumpleistung benötigt wird.

Von der Decke der Fertigungseinheit 1 am linken Rand der Figur 2 führt eine zweite Entsorgungsleitung 8b nach oben zu einem in der darüberliegenden Etage 9 angeordneten, als Gasreservoir 15 ausgebildeten Vorratsbehälter. Über diese Entsorgungsleitung 8a wird kontaminierte und erhitzte Luft aus dem Inneren der Fertigungseinheit 1 in das Gasreservoir 15 geleitet. Dort wird die kontaminierte Luft gereinigt und über einen Abluftschacht 16 aus dem Gebäude 5 geleitet. Da die erwärmte kontaminierte Luft leichter als die von der Umgebungsluft gebildete Atmosphäre ist, steigt die erwärmte Luft in der Fertigungseinheit 1 nach oben und kann dort mit geringem Energieaufwand abgesaugt und der Entsorgungsleitung 8b zugeführt werden. Über eine nicht dargestellte Ansaugvorrichtung in der Wand der Fertigungseinheit 1 kann die Versorgung mit unverbrauchter Luft aus dem Reinraum 2 erfolgen.

Die mittlere in Figur 2 dargestellte Fertigungseinheit 1 kann insbesondere zur Durchführung von Ätzprozessen dienen. Hierzu werden Atzlösungen aus einem von einem ersten Tank 17 gebildeten Vorratsbehälter über erste Versorgungsleitungen 7a der Fertigungseinheit 1 zugeführt. Nach Gebrauch in der Fertigungseinheit 1 werden die Ätzlösungen über erste Entsorgungsleitungen 8a in einen zweiten Tank 18 abgelassen. Dabei ist der erste Tank 17 in der Etage 9 oberhalb des Reinraums 2 und der zweite Tank 18 in der Etage 10 unterhalb des Reinraums 2 angeordnet, so daß die Ätzlösungen in den Versorgungs- 7a und Entsorgungsleitungen 8a von oben nach unten verlaufen. Auf diese Weise ist eine Zufuhr und Abfuhr der Ätzlösungen zu und von der Fertigungseinheit 1 ohne oder nahezu ohne den Einsatz von Pumpen möglich.

Bei der am rechten Rand der in Figur 2 dargestellten Fertigungseinheit 1 handelt es sich um eine Fertigungseinheit 1, welcher ein erhitztes Gas, das leichter als die umgebende Luftatmosphäre ist, zugeführt wird. Um den Energieaufwand für die Zufuhr des Gases zu der Fertigungseinheit 1 gering zu halten, ist ein als Gasreservoir 19 ausgebildeten Vorratsbehälter mit dem Gas in der Etage 10 direkt unterhalb des Reinraums 2 angeordnet. Von dem Gasreservoir 19 führt eine zweite Versorgungsleitung 7b nach oben zur Fertigungseinheit 1 und durchsetzt dabei den Boden 12 des Reinraums 2. Die Versorgungsleitung 7a verläuft dabei über nahezu die gesamte Länge senkrecht nach oben so daß die Konvektionsbewegung des Gases optimal ausgenützt wird.

Entsprechend führt von der Decke der Fertigungseinheit 1 eine zweite Entsorgungsleitung 8b zu einem Vorratsbehälter, der von einem zweiten Gasreservoir 20 gebildet ist. Dieses Gasreservoir 20 ist auf der über dem Reinraum 2 liegenden Etage 9 direkt oberhalb der entsprechenden Fertigungseinheit 1 angeordnet, so daß auch in diesem Fall die Entsorgungsleitung 8b von einem Anschluß an der Fertigungseinheit 1 senkrecht nach oben verläuft und über einen nicht dargestellten Anschluß in das Gasreservoir 20 mündet.

## Patentansprüche

1. Anlage zur Fertigung von Halbleiterprodukten, insbesondere zur Bearbeitung von Wafern, mit einer Anordnung von Fertigungseinheiten in wenigstens einem Reinraum sowie mit einem Versorgungssystem zur Versorgung und Entsorgung von Betriebsstoffen für die Fertigungseinheiten,
**dadurch gekennzeichnet, daß**
das Versorgungssystem erste Versorgungs- (7a) und Entsorgungsleitungen (8a) aufweist, in welchen Betriebsstoffe, welche schwerer als die umgebende Atmosphäre sind, von oben nach unten geführt sind, und zweite Versorgungs- (7b) und Entsorgungsleitungen (8b) aufweist, in welchen Betriebsstoffe, die leichter als die umgebende Atmosphäre sind, von unten nach oben geführt sind.

2. Anlage nach Anspruch 1,
**dadurch gekennzeichnet, daß**
sich der Reinraum (2) in einer Etage (6) eines Gebäudes (5) befindet, und daß sich wenigstens in einer darüber und darunter liegenden Etage (9, 10) des Gebäudes (5) Vorratsbehälter zur Aufnahme der Betriebsstoffe befinden.

3. Anlage nach Anspruch 2,
**dadurch gekennzeichnet, daß**
die Vorratsbehälter für flüssige Betriebsstoffe und gasförmige Betriebsstoffe, die schwerer als die umgebende Atmosphäre sind, und welche über die ersten Versorgungsleitungen (7a) den Fertigungseinheiten (1) zuführbar sind, in Etagen (9) oberhalb des Reinraums (2) angeordnet sind.

4. Anlage nach Anspruch 3,
**dadurch gekennzeichnet, daß**
die Vorratsbehälter zur Aufnahme von flüssigen oder gasförmigen Betriebsstoffen, die schwerer als die umgebende Atmosphäre sind, und welchen die Betriebsstoffe über die ersten Ent sorgungsleitungen (8a) zuführbar sind, in den Etagen (10) unterhalb des Reinraums (2) angeordnet sind.

5. Anlage nach einem der Ansprüche 2 - 4,
**dadurch gekennzeichnet, daß**
Vorratsbehälter für gasförmige Betriebsstoffe, die leichter als die umgebende Atmosphäre sind, und welche über die zweiten Versorgungsleitungen (7b) den Fertigungseinheiten (1) zuführbar sind, in Etagen (10) unterhalb des Reinraums (2) angeordnet sind.

6. Anlage nach Anspruch 5,
**dadurch gekennzeichnet, daß**
die Vorratsbehälter zur Aufnahme von gasförmigen Betriebsstoffen, die leichter als die umgebende Atmosphäre sind, und welchen die Betriebsstoffe über die zweiten Entsorgungsleitungen (8b) zuführbar sind, in Etagen (9) oberhalb des Reinraums (2) angeordnet sind.

7. Anlage nach Anspruch 6,
**dadurch gekennzeichnet, daß**
die Vorratsbehälter zur Aufnahme von aus den Fertigungseinheiten (1) abgeführten flüssigen Betriebsstoffen als Auffangbehälter (14) ausgebildet sind.

8. Anlage nach einem der Ansprüche 1 - 7,
**dadurch gekennzeichnet, daß**
die ersten Versorgungsleitungen (7a) und die zweiten Entsorgungsleitungen (8b) über die Decke (11) des Reinraums (2) geführt sind.

9. Anlage nach einem der Ansprüche 1 - 8,
**dadurch gekennzeichnet, daß**
die zweiten Versorgungsleitungen (7b) und die ersten Entsorgungsleitungen (8a) über den Boden (12) des Reinraums (2) geführt sind.

10. Anlage nach einem der Ansprüche 1 - 9,
**dadurch gekennzeichnet, daß** die Betriebsstoffe
als flüssigen Betriebsstoff Reinstwasser, Reinwasser oder Kühlwasser umfassen.

11. Anlage nach einem der Ansprüche 5 - 10,
**dadurch gekennzeichnet, daß** die Betriebsstoffe
als flüssige Betriebsstoffe Flüssig-Chemikalien umfassen.

12. Anlage nach Anspruch 11,
**dadurch gekennzeichnet, daß**
die Flüssig-Chemikalien von Ätzlösungen, insbesondere KOH oder NaOH, zur Durchführung von Ätzprozessen gebildet sind.

13. Anlage nach Anspruch 11 oder 12,
**dadurch gekennzeichnet, daß**
die Flüssig-Chemikalien von alkalischen oder sauren Lösungen zur Reinigung der Wafer gebildet sind.

14. Anlage nach einem der Ansprüche 1 - 13,
**dadurch gekennzeichnet, daß** die Betriebsstoffe
als gasförmigen Betriebsstoff erwärmte und kontaminierte Abluft umfassen, die in einen Vorratsbehälter oberhalb der Fertigungseinheit (1) entsorgt wird.

15. Anlage nach einem der Ansprüche 1 - 14,
**dadurch gekennzeichnet, daß** die Betriebsstoffe
als gasförmige Betriebsstoffe Ätzgase zur Durchführung von Ätzprozessen umfassen.

16. Anlage nach Anspruch 15,
**dadurch gekennzeichnet, daß**
die Ätzgase von Halogenverbindungen gebildet sind.

17. Anlage nach einem der Ansprüche 1 - 16,
**dadurch gekennzeichnet, daß** die Betriebsstoffe
als gasförmige Betriebsstoffe Sauerstoff zur Reinigung und Stickstoff zur Trocknung von Wafern bei Reinigungsprozessen umfassen.

## Claims

1. Installation for the fabrication of semiconductor products, in particular for the processing of wafers, having an arrangement of fabrication units in at least one clean room and having a supply system for supplying and discharging operating substances for the fabrication units, **characterized in that** the supply system has first supply lines (7a) and discharge lines (8a), in which operating substances which are heavier than the surrounding atmosphere are guided from the top downward, and second supply lines (7b) and discharge lines (8b), in which operating substances which are lighter than the surrounding atmosphere are guided from the bottom upward.

2. Installation according to Claim 1, **characterized in that** the clean room (2) is located in one storey (6) of a building (5), and **in that** reservoirs for holding the operating substances are situated at least on a higher storey (9) and a lower storey (10) of the building (5).

3. Installation according to Claim 2, **characterized in that** the reservoirs for liquid operating substances and gaseous operating substances which are heavier than the surrounding atmosphere and which can be fed to the fabrication units (1) via the first supply lines (7a) are arranged in storeys (9) which are above the clean room (2).

4. Installation according to Claim 3, **characterized in that** the reservoirs for holding liquid or gaseous operating substances which are heavier than the surrounding atmosphere and to which the operating substances can be supplied via the first discharge lines (8a) are arranged in the storeys (10) which lie below the clean room (2).

5. Installation according to one of Claims 2 to 4, **characterized in that** reservoirs for gaseous operating substances which are lighter than the surrounding atmosphere and which can be fed to the fabrication units (1) via the second supply lines (7b) are arranged in storeys (10) which lie below the clean room (2).

6. Installation according to Claim 5, **characterized in that** the reservoirs for holding gaseous operating substances which are lighter than the surrounding atmosphere and to which the operating substances can be fed via the second discharge lines (8b) are arranged in storeys (9) which lie above the clean room (2).

7. Installation according to Claim 6, **characterized in that** the reservoirs for holding liquid operating substances which have been removed from the fabrication units (1) are designed as collection vessels (14).

8. Installation according to one of Claims 1 to 7, **characterized in that** the first supply lines (7a) and the second discharge lines (8b) are guided over the ceiling (11) of the clean room (2).

9. Installation according to one of Claims 1-8, **characterized in that** the second supply lines (7b) and the first discharge lines (8a) are guided over the floor (12) of the clean room (2).

10. Installation according to one of Claims 1-9, **characterized in that** the operating substances comprise, as liquid operating substance, ultrapure water, pure water or cooling water.

11. Installation according to one of Claims 5-10, **characterized in that** the operating substances comprise, as liquid operating substances, liquid chemicals.

12. Installation according to Claim 11, **characterized in that** the liquid chemicals are formed by etching solutions, in particular KOH or NaOH, for carrying out etching processes.

13. Installation according to Claim 11 or 12, **characterized in that** the liquid chemicals are formed by alkaline or acidic solutions for cleaning the wafers.

14. Installation according to one of Claims 1-13, **characterized in that** the operating substances comprise, as gaseous operating substance, heated and contaminated waste air which is discharged into a reservoir above the fabrication unit (1).

15. Installation according to one of Claims 1-14, **characterized in that** the operating substances, as gaseous operating substances, comprise etching gases for carrying out etching processes.

16. Installation according to Claim 15, **characterized in that** the etching gases are formed by halogen compounds.

17. Installation according to one of Claims 1-16, **characterized in that** the operating substances comprise, as gaseous operating substances, oxygen for cleaning and nitrogen for drying wafers during cleaning processes.

## Revendications

1. Installation de fabrication de produits semi-conducteurs, notamment de traitement de tranches, comprenant un agencement d'unités de fabrication dans au moins une salle blanche, ainsi qu'un système d'alimentation pour l'alimentation et l'évacuation de substances de fonctionnement pour les unités de fabrication,
**caractérisée en ce que**
le système d'alimentation comprend des premiers conduits (7a) d'alimentation et des premiers conduits (8a) d'évacuation, dans lesquels des substances de fonctionnement, qui sont plus lourdes que l'atmosphère ambiante, passent de haut en bas et des deuxièmes conduits (7b) d'alimentation et des deuxièmes conduits (8b) d'évacuation, dans lesquels des substances de fonctionnement qui sont plus légères que l'atmosphère ambiante passent de bas en haut.

2. Installation suivant la revendication 1,
**caractérisée en ce que**
la salle (2) blanche se trouve dans un étage (6) d'un bâtiment (5) et **en ce que** au moins dans un étage (9n 10) du bâtiment (5) se trouvant au-dessus et en dessous, se trouvent des réservoirs de réception des substances de fonctionnement.

3. Installation suivant la revendication 2,
**caractérisée en ce que**
les réservoirs pour des substances de fonctionnement liquides et pour des substances de fonctionnement gazeuses, qui sont plus lourdes que l'atmosphère ambiante et qui peuvent être ramenées par les premiers conduits (7a) d'alimentation aux unités (1) de fabrication, sont disposés dans des étages (9) au-dessus de la chambre (2) blanche.

4. Installation suivant la revendication 3,
**caractérisée en ce que**
les réservoirs de réception de substances de fonctionnement liquides ou gazeuses, qui sont plus lourdes que l'atmosphère ambiante, et auxquels les substances de fonctionnement peuvent être envoyées par les premiers conduits (8a) d'évacuation, sont disposés dans les étages (10) en dessous de la salle (2) blanche.

5. Installation suivant l'une des revendications 2 à 4,
**caractérisée en ce que**
les réservoirs pour des substances de fonctionnement gazeuses, qui sont plus légères que l'atmosphère ambiante et qui peuvent être envoyées par les deuxièmes conduits (7b) d'alimentation aux unités (1) de fabrication, sont disposés dans des étages (10) en dessous de la salle (2) blanche.

6. Installation suivant la revendication 5,
**caractérisée en ce que**
les réservoirs de réception de substances de fonctionnement gazeuses, qui sont plus légères que l'atmosphère ambiante, et auxquels des substances de fonctionnement peuvent être envoyées par les deuxièmes conduits (8b) d'évacuation, sont disposés au-dessus de la salle (2) blanche.

7. Installation suivant la revendication 6,
**caractérisée en ce que**
les réservoirs de réception des substances de fonctionnement liquides évacuées des unités (1) de fabrication sont constitués en cuves (14) de captage.

8. Installation suivant l'une des revendications 1 à 7,
**caractérisée en ce que**
les premiers conduits (7a) d'alimentation et les deuxièmes conduits (8b) d'évacuation passent dans le plafond (11) de la chambre (2) blanche.

9. Installation suivant l'une des revendications 1 à 8,
**caractérisée en ce que**
les deuxièmes conduits (7b) d'alimentation et les premiers conduits (8a) d'évacuation passent dans le plancher (12) de la salle (2) blanche.

10. Installation suivant l'une des revendications 1 à 9,
**caractérisée en ce que** les substances de fonctionnement comprennent, comme substances de fonctionnement liquides, de l'eau extra pure , de l'eau pure ou de l'eau de refroidissement.

11. Installation suivant l'une des revendications 5 à 10,
**caractérisée en ce que** les substances de fonctionnement comprennent, comme substances de fonctionnement liquides, de produits chimiques liquides.

12. Installation suivant la revendication 11,
**caractérisée en ce que**
les produits chimiques liquides sont formés par des solutions d'attaque, notamment de KOH ou de NaOH, pour effectuer des opérations d'attaque.

13. Installation suivant la revendication 11 ou 12,
**caractérisée en ce que**
les produits chimiques liquides sont formés par des solutions alcalines ou acides de nettoyage des tranches.

14. Installation suivant l'une des revendications 1 à 13,
**caractérisée en ce que** les substances de fonctionnement comprennent, comme substances de fonctionnement gazeuses, de l'air effluent chauffé et pollué qui est évacué dans un réservoir au-dessus de l'unité (1) de fabrication.

15. Installation suivant l'une des revendications 1 à 14,
**caractérisée en ce que** les substances de fonctionnement comprennent, comme substances de fonctionnement gazeuses, des gaz d'attaque pour effectuer des opérations d'attaque.

16. Installation suivant la revendication 15,
**caractérisée en ce que**
les gaz d'attaque sont formés par des composés halogénés.

17. Installation suivant l'une des revendications 1 à 16,
**caractérisée en ce que** les substances de fonctionnement comprennent, comme substances de fonctionnement gazeuses, de l'oxygène pour le nettoyage et de l'azote pour le séchage de tranches dans des opérations de nettoyage.
